# EUROPEAN PATENT APPLICATION

(11) **EP 3 057 149 A1**
(43) Date of publication of application: **17.08.2016**
(21) Application number: 15000413.3
(22) Date of filing: 11.02.2015
(51) Int. Cl.: H01L 51/00, H01L 51/52, F21V 21/08

(54) **Kits comprising TOLED-containing multilayer films for providing windows with an image display**

(71) Applicant: NITTO EUROPE N.V, 3600 Genk (BE)
(72) Inventor: Jaspers, Alex, 3600 Genk (BE); Yanai, Masashi, 3600 Genk (BE); Forier, Bart, 3600 Genk (BE)
(74) Representative: Grünecker Patent- und Rechtsanwälte PartG mbB

(57) **Abstract**

Disclosed is a kit which may be used to provide windows, such as windows of a vehicle or a building, with an image display. The kit comprises a transparent multilayer film which comprises a release liner; a pressure-sensitive, optically clear adhesive layer; a transparent flexible substrate; transparent electrically conductive layer; a transparent organic light-emitting device (TOLED) region electrically connected with the transparent electrically conductive layer; an encapsulation layer configured to encapsulate the transparent electrically conductive layer and the TOLED region; and a protective film. The images displays provided by using the kit have a favourably long visibility range and are at the same time nearly invisible when inactive. The use of such kits to provide windows with an image display, e.g. windows having a safety light function, and windows modified accordingly are also disclosed.

## Description

### FIELD OF THE INVENTION

The present invention is directed to a kit for providing windows, such as windows of a vehicle or a building, with an image display, wherein the kit comprises a multilayer adhesive film comprising a transparent organic light-emitting device (TOLED).

The present invention is further directed to the use of such kits to provide windows with an image display and to windows modified accordingly.

### BACKGROUND OF THE INVENTION

Transparent organic-light emitting devices (TOLED) encompass OLED technology in transparent glass or plastic substrates that are capable of emitting light from the top or bottom, or both. Because TOLED displays that emit from both top and bottom exhibit a transparency of at least 70% when not in use, provide favourable brightness and high viewing angles, and may be manufactured on flexible substrates, they have found widespread applications in eyeglasses and windows of buildings and vehicles, for example.

The implementation of transparent OLEDs in building windows for indoor illumination purposes is e.g. known from WO 2012/138659 A2 and WO 2008/135893 A1.

TOLED technology has also been widely used in the development of head-up displays in windshields of motor vehicles to provide the operator with information within his field of vision. Windshields comprising such head-up displays usually consist of a laminated structure having a plurality of glass layers, between which the TOLED is encapsulated in order to prevent the TOLED from degradation by exposure to moisture or oxygen, and wherein the light-emitting pixels of the TOLED are supplied with voltage with transparent, electrically conductive material such as indium tinoxide (ITO) or polyethylenethioxythiophene (PEDOT) extending to the edge of the windshield. Such laminated windshields are disclosed in US 2005/0084659 A1, for example.

From the viewpoint of road safety, it is desirable to provide vehicle windows with TOLED displays that are configured in a manner which allows the visual information to be viewed from the outside of the vehicle, wherein the display has ideally both a wide viewing angle and a long-distance visibility. Thereby, image displays that may also have the function of safety lights (e.g. warning lights, turning signs or a warning triangle) could be effectively implemented. This would be especially desirable to immediately warn road users in case of emergency situations or vehicle malfunctions on highways, where the driver is exposed to risks when getting out of the vehicle to set up a warning triangle.

DE 10 2007 012 571 A1 proposes the use of TOLED displays in glass sandwich constructions in order to provide additional turning signs.

However, the production process for laminated glass sandwich constructions as disclosed in US 2005/0084659 A1 or DE 10 2007 012 571 A1 is intricate. Furthermore, in case of breakage, the entire window construction including the TOLED display must be replaced, which amounts to high repair costs.

US 2012/0274458 A1 discloses a back window for a motor vehicle comprising a separate display element for information relating to a parking process. Said display element comprises a light conductor panel and a light source placed on the back shelf of the vehicle, wherein light-diffusing nano particles are incorporated in the light conductor panel. By coupling-in light from the light source via the marginal surface of the display element, the light-diffusing particles cause the light to be radiated towards the direction of the driver. However, said system is disadvantageous in that it is not configured for outward light radiation and in that the light source must be placed and adjusted correctly, which imposes limitations on the geometry of the window and the vehicle interior (e.g. window curvature, geometry of back shelf).

Furthermore, while TOLED displays generally provide excellent viewing angle characteristics, their long-range visibility is in need of improvement, especially when used in safety light applications.

Accordingly, the provision of TOLED-implemented windows that overcome the above disadvantages is desirable.

### SUMMARY OF THE INVENTION

The present invention solves this object with the subject matter of the claims as defined herein. The advantages of the present invention will be further explained in detail in the section below and further advantages will become apparent to the skilled artisan upon consideration of the invention disclosure.

In one aspect, the present invention provides a kit for equipping windows with an image display, wherein the kit comprises a transparent multilayer film which comprises: a release liner; a pressure-sensitive, optically clear adhesive layer; a transparent flexible substrate; a transparent electrically conductive layer; a TOLED region electrically connected with the transparent electrically conductive layer; an encapsulation layer configured to encapsulate the transparent conductive oxide and the TOLED region; and a protective film.

The kit as defined herein has the advantage that it incorporates an image display with a long visibility range and is at the same time nearly invisible when inactive. Through its flexibility, it may be applied on various transparent surfaces with curved geometries, such as back windows of vehicles, without requiring any further modification of the window substrates or any light source adjustments such as in illumination devices. At the same time, the kit further improves the breaking stability of the substrate and reduces the danger of injuries and damages due to glass splintering upon breakage. Furthermore, by selecting the adhesive layer so that it may be releasably adhered to the window substrate, the kit may be re-used. Thus, in case the window substrate is damaged and has cracks, for example, it is not necessary to replace the entire TOLED-equipped window construction.

In a further aspect, the present invention provides windows comprising a window base material and a multilayer film provided on one surface of the window base material, wherein the multilayer film comprises: an optically clear adhesive layer attached to a surface of the window base; a transparent flexible substrate; transparent electrically conductive layer; a TOLED region electrically connected with the transparent electrically conductive layer; an encapsulation layer configured to encapsulate the transparent electrically conductive layer and the TOLED region; and a protective film.

In an additional aspect, the present invention is directed to the use of the kit described above in order to provide windows with an image display.

### BRIEF DESCRIPTION OF THE DRAWINGS

Fig. 1 a schematically illustrates an exemplary configuration of a kit of the present invention.
Fig. 1b schematically illustrates an exemplary configuration of a window of the present invention.
Fig. 2 illustrates the implementation an image display with a safety light function into the back window of a vehicle as an exemplary use of the windows and kits according to the invention.

### DETAILED DESCRIPTION

For a more complete understanding of the present invention, reference is now made to the following description of the illustrative embodiments thereof:

### Kit for providing windows with an image display

A first embodiment of the present invention is a kit for providing windows with an image display, wherein the kit comprises a transparent multilayer film, the multilayer film comprising: a release liner; a pressure-sensitive, optically clear adhesive layer; a transparent flexible substrate; transparent electrically conductive layer; a TOLED region electrically connected with the transparent electrically conductive layer; an encapsulation layer configured to encapsulate the transparent electrically conductive layer and the TOLED region; and a protective film.

Preferably, the transparent multilayer film exhibits a light transmissivity determined according to JIS C6714 of at least 60% or, more preferably, at least 80%.

The multilayer film comprises an optically clear adhesive layer through which the multilayer film is attached onto at least one part of the surface of the window base material. The optically clear adhesive used to form the optically clear adhesive layer is not particularly limited and may include e.g. acrylate-based adhesives. The optically clear adhesive layer may be, for example, a low-temperature-curable adhesive layer or a radiation-curable adhesive layer, such as e.g. a UV-curable adhesive layer. The optically clear adhesive layer also preferably has low out-gassing properties. Depending on the intended use, the skilled artisan will select the optically clear adhesive according to the desired peel properties (e.g. peel strength, peel residue) of the multilayer film. For instance, for some applications, such as re-use of the multilayer film or in case of breakage of the window substrate, easy detachment of the latter from the window base may be preferable.

The transparent flexible substrate comprised in the multilayer film is not particularly limited and includes metal layers, semiconductor layers, glass layers, ceramic layers, polymer layers, composite material layers and combinations thereof. As exemplary material for polymer layers, polyamides, polyethylene terephthalate (PET), elastomeric polydimethylsiloxane (PDMS), polyethylene naphthalate (PEN), polycarbonates, polyethersulfones, cyclic olefin polymers, polyarylates, and polyimides may be mentioned. The transparent flexible substrate employed in accordance with the present invention, like the encapsulation layer, provides a barrier function and/or encapsulation function to protect the encapsulated TOLED region. The transparent flexible substrate, together with the top encapsulation layer creates the required complete encapsulation function for the TOLED. Regarding the required encapsulation properties, reference is made to the respective description of the transparent encapsulation layer (also designated top encapsulate layer).

The electrically conductive layer provides an electrical connection with the TOLED, supplying voltage to its light-emitting pixels and thereby activating the TOLED. For this purpose, the electrically conductive layer is formed in a pattern which covers only a part of the multilayer film. The layer is formed of transparent, electrically conductive material such as transparent conductive metals (e.g. copper, silver nanowire etc.), transparent conductive oxides or organic conductive material, such as e.g. polyethylenethioxythiophene (PEDOT), conducting polyanilines, polypyrroles and polythiophenes. Preferably, transparent conductive oxides are used. As examples of transparent conductive oxides, n-type or p-type transparent conductive oxides may be mentioned. Specific examples include indium tin oxide (ITO), fluorine doped tin oxide (FTO), aluminum-doped zinc oxide (AZO), indium zinc oxide, cadmium tin oxide (CTO) or zinc oxide. '

The TOLED elements to be used with the present invention may have numerous configurations. An exemplary TOLED configuration comprises an anode layer, a light-emitting layer, and a cathode layer. The light-emitting layer may be provided in connection with a number of configurations, such as a three-layer configuration comprising (a) hole transporting sub-layer(s), (an) emission sub-layer(s) and (an) electron transporting sublayer(s), a two-layer configuration comprising (a) hole transporting sub-layer(s) and (a) sub-layer(s) that provide(s) both emission and electron transporting functions and a configuration comprising a single layer that provides hole transporting, electron transporting and emission functions. In each configuration, additional layers may also be present, for example, hole- and/or electron injection layers or hole- and/or electron-blocking layers.

The image to be displayed is not particularly limited and includes lettering, symbols, and graphics (e.g. for the purposes of advertisement, warnings, information, entertainment etc.). In a preferred embodiment, the image display is a safety light (e.g. a warning light, turning sign or a warning triangle). For such a purpose, the TOLED region may be arranged in a specific pattern, such as the pattern of a warning triangle, a warning sign, lettering or other symbols. In a more preferred embodiment, the TOLED region is arranged in the pattern of a warning triangle.

The encapsulation layer as used for the present invention is configured to encapsulate the transparent electrically conductive layer and the TOLED.

Preferably, the kit according to the present invention further comprises a control unit, which may be provided as a printed flexible electronic circuit in connection with the transparent electrically conductive layer. In a further preferred embodiment, the control unit is preferably positioned in the multilayer film. The control unit is connected to an internal or external power supply and may be configured to receive signals from an external source, such as a computer operating system, and/or comprise an internal, active, flexible printed circuit, such as a flasher circuit for safety light applications. Preferably, the kit comprises connecting means for the connection of the control unit to an external power supply, which may be the power line of a vehicle or a wall wart, for example.

In a preferred embodiment, the kit further comprises an activating means for activating the image display. In a more preferred embodiment, the kit comprises an external on/off signal transmitter (switch) which is connected via a wired or wireless connection with an on/off-signal receiver comprised in the control unit. Even more preferably, the kit comprises an external on/off signal transmitter (switch) which is connected via a wireless connection with an on/off-signal receiver comprised in the control unit. In an alternative preferred embodiment, the on/off signal transmitter may be implemented into safety switches already present in the window-comprising means on which the kit is to be applied, such as e.g. conventional hazard buttons in vehicles, alarm switches in buildings etc..

The transparent encapsulation layer configured to encapsulate the electrically conductive layer and the TOLED region may be composed of materials commonly used in the art for encapsulating flexible electronic devices, such as inorganic or a combination of inorganic and organic materials. Inorganic materials may provide an effective barrier against the permeation of moisture and oxygen, while organic materials tend to provide improved mechanical flexibility.

The protective layer provides an additional barrier towards moisture, oxygen and mechanical and thermal stress. The material used for the protective layer may be any material known in the art which serves said purpose and does not negatively impact the flexibility of the multilayer film. As examples for said material, a material selected from a silicon oxide, a silicon nitride, a silicon oxynitride, a metal oxide, an organic compound, and/or an organometallic compound may be mentioned. As another example, the protective layer comprises one or more high-density sub-layers and one or more planarizing sub-layers.

The release liner is not particularly limited and includes single- or multilayer films or sheets constituted of thermoplastic resins (e.g., films or sheets constituted of known thermoplastic resins such as polyolefin resins, polyamide resins, polyesters, styrene resins, poly(vinyl chloride)) and metal foils, for example, wherein the single- or multilayer films or sheets may be coated with release agents.

Other functional layers may be comprised within the multilayer film to provide additional functions, such as e.g. UV-absorbance, heat absorbance or reflectance, scratch resistance. For example, in order to improve the scratch and/or breaking resistance, one or multiple additional layers based on materials such as polyethylene terephtalate (PET), polyurethane (e.g. thermoplastic polyurethane) may be comprised in the multilayer film.

The above sublayers of the multilayer film may be arranged in several configurations, and may depend on which side of a window substrate (e.g. in- or outside of a vehicle window) the film is to be mounted.

In a preferred embodiment, the TOLED region is not in direct contact with the adhesive layer of the organic electronic device structure in order to prevent the adhesive layer from physically damaging the TOLED. More preferably, an additional barrier layer is interposed between the adhesive layer and the TOLED layer. Even more preferably, the barrier between the adhesive layer and the TOLED layer is formed by arranging the transparent flexible substrate layer and the transparent electrically conductive layer between the adhesive layer and the TOLED layer.

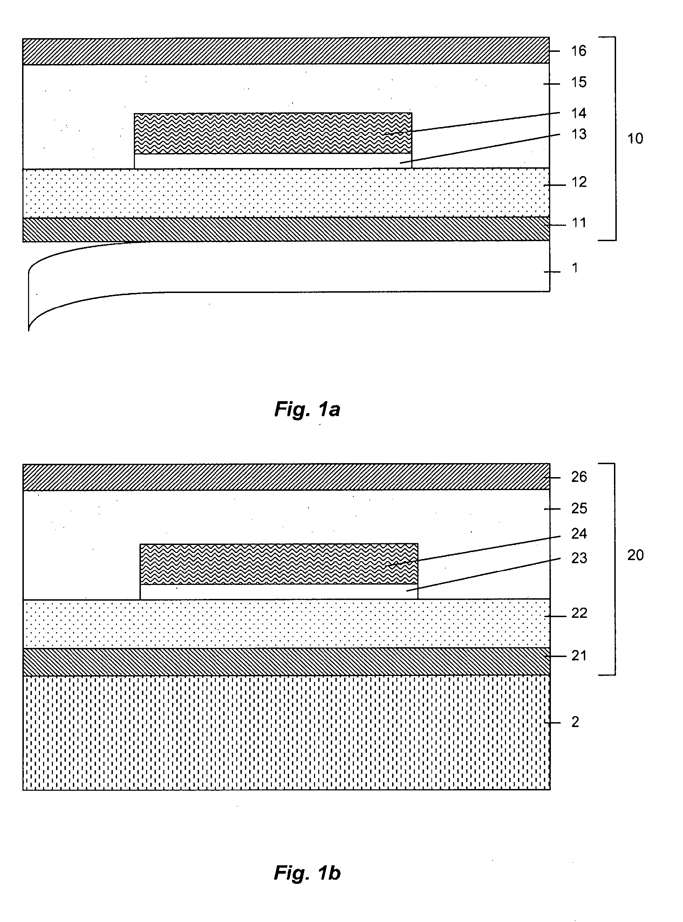

An exemplary configuration of a multilayer film (10) as comprised in the kit of the present invention is shown in Fig. 1 a. Herein, a release liner (1) is provided on one surface of the adhesive layer (11) and a transparent flexible substrate layer (12) on the other. The transparent electrically conductive layer (13) is provided on the flexible substrate layer (12). The TOLED region (14) is provided on the electrically conductive layer (13), with the latter layers 13 and 14 being encapsulated with the encapsulation layer (15). A protective film (16) is provided on the encapsulation layer. Said configuration is preferable in that it allows to fabricate thin multilayer films having a favourable balance between flexibility and encapsulation properties. Figure 1 a describes a configuration of the multilayer film (10) wherein the release liner (1) and the adhesive layer (11) are provided on one side of the transparent flexible substrate layer (12), whereas the TOLED function is provided on the other side of the transparent flexible substrate layer (12). The present invention, however, also encompasses configurations wherein the adhesive layer (11) and the release liner (1) are provided on the other side of the transparent structure, i.e. are provided on the outer surface of the protective film (16). Due of the fact that the TOLED functionality is a transparent stack, it is also possible to provide the adhesive layer and the release liner on another side of the overall stack of layers (16) to (12). These alternative configurations do not solely apply to the configuration of the multilayer film (10) as depicted in figure 1a, but also to all other exemplary configurations shown in the present application as well as the further configurations derivable from the general part of the specification.

In a preferred embodiment, the kit may further comprise an optically transparent light guiding layer, which may be present either as an additional layer comprised in the multilayer film or within a pressure-sensitive adhesive film provided in the kit separately from the multilayer film.

The optically transparent light guiding layer is characterized in that it comprises on at least one surface thereof a plurality of microstructures (such as grooves, for example) which have an optical path changing slope altering the direction of the optical path of the light emitted from the TOLED region. The microstructures may appear in the crossectional shape of the optically transparent light guiding layer as concave/convex portions having a triangular, parabolic, square or hexagonal form. Exemplary embodiments for such microstructures are disclosed in US 2011/0296795 A1, EP 1 114 235 A1 and US 2012/0120496 A1. Depending on the field of application, the optical path changing slope may be selected so that the optical path of the light emitted from the TOLED region is redirected towards the direction in which the target subject (e.g. person to be warned) is to be expected. For example, when the kit is to be applied on the slanted back window of a vehicle, it is preferable that the optical path changing slope is configured so that the optical path of the light emitted from the TOLED region vertically (where no road user is usually to be found) is redirected towards the horizontal plane, so that the vertical component of the light emitted from the TOLED is guided to a direction where following and surrounding road users are expected. By increasing the intensity of light emitted from the TOLED in the target direction accordingly, the wide-distance visibility of the light emitted may be significantly improved.

The material used for the optically transparent light guiding layer is not particularly limited as long as the layer serves the stated function and provides sufficient flexibility to be applied within (or as) a pressure-sensitive adhesive film.

It is preferable that the optically transparent light guiding layer is provided at a position between the TOLED layer and the target subject (i.e. person to be warned).

As mentioned above the optically transparent light guiding layer may be comprised in the kit within a film separate from the multilayer film described above. Such an optically transparent light guiding film may comprise an additional pressure-sensitive adhesive layer with a release liner and may further comprise additional layers, such as a protective film layer, for example. Thus, the multilayer film as defined above may be applied on one surface of the window, and the optically transparent light guiding layer film on the other surface of the window, i.e. the window surface opposed to the multilayer film.

The kit as defined hereinabove has the advantage that it incorporates an image display which may be viewed from long distances and is at the same time nearly invisible when inactive. Through its flexibility, it may be applied on various transparent surfaces with curved geometries, such as e.g. back windows of vehicles, without requiring any further modification of the window substrates or any light source adjustments such as in illumination devices and is formable using web-based, roll-to-roll manufacturing techniques. At the same time, the kit further improves the breaking stability of the substrate and reduces the danger of injuries and damages due to glass splintering upon breakage. Furthermore, by selecting the adhesive layer so that it may be releasably adhered to the window substrate, the kit may be re-used. Thus, in case the window substrate is damaged (e.g. having cracks), it is not necessarily required to replace the entire TOLED-equipped window construction.

### Window with an image display

A second embodiment according to the present invention is a window, onto which the kit as described in the first embodiment has been applied by removing the release liner and adhering the multilayer film onto one surface of a window base (and optionally, if provided separately, an optically transparent light guiding film as described above on the other surface of the window base). As such, the window according to the present invention comprises a window base material and a transparent multilayer film provided on one surface of the window base material, wherein the multilayer film may be defined as described in connection with the first embodiment as set out above, with the exception that it does not comprise a release liner. In this embodiment, the multilayer film (without release liner) is attached onto at least one part of the surface of the window base material through the optically clear adhesive layer.

The window base material is not particularly limited and includes materials conventionally used in the manufacture of glass windows for buildings and vehicles, such as e.g. toughened, tempered or partly tempered glass, laminated glass (e.g. safety glass for windshields, which usually includes two plies of glass sandwiching an interlayer of plastic material (e.g. polyvinyl butyral)), insulated glass (e.g. multi-pane glazing), wire glass, self-cleaning glass, or smart/switchable glass.

An exemplary configuration of a window according to the present invention is shown in Fig. 1 a. Herein, the multilayer film (20) comprising, in the stated order, an adhesive layer (21), a transparent flexible substrate layer (22), the transparent electrically conductive layer (23), a TOLED region (24), and an encapsulation layer (25) encapsulating the TOLED region (24) and the transparent electrically conductive layer (23), is attached via the adhesive layer to the window base (2).

In a preferred embodiment, the window according to the present invention comprises an optically transparent light guiding layer as described in connection with the first embodiment. The optically transparent light guiding layer may be present as an additional layer comprised in the multilayer film. Alternatively, the optically transparent light guiding layer may be provided on the surface of the window base opposing the multilayer film. In the latter configuration, additional layers, such as e.g. a pressure-sensitive adhesive layer, may be interposed between the window base and the optically transparent light guiding layer.

### Use of the kit to provide windows with an image display

A third embodiment of the present invention is directed to the use of the kit as described in the first embodiment in order to provide windows with an image display. Preferably, the use of the kit comprises the steps of removing the release liner of the transparent multilayer film, and adhering the transparent multilayer film to one surface of a window.

As an example of the third embodiment, the use of the kit according to the first embodiment on windows of vehicles to provide a safety light with an excellent visibility may be mentioned. Such a safety light may include a warning triangle, a warning sign, lettering or other symbols having the purpose of warning other road users.

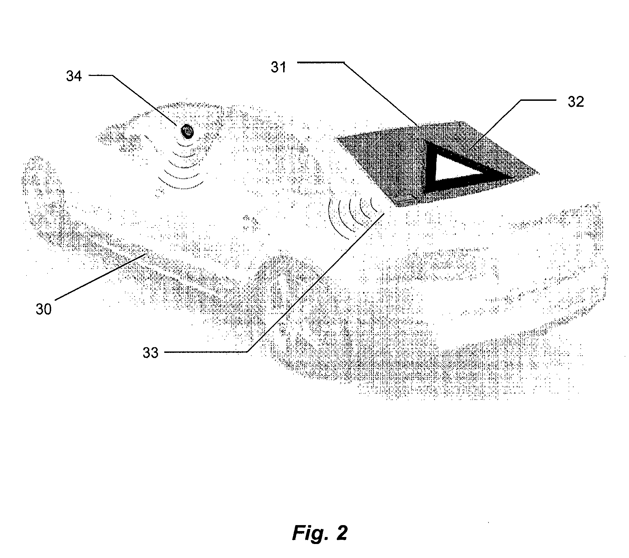

A specific example of the use of the kit of the present invention is illustrated in Fig. 2. Fig. 2 displays a vehicle (30), onto which a kit as defined in the first embodiment has been applied by removing the release liner and adhering the transparent multilayer film onto a surface of rear window to provide a rear window with a warning light function (31). Since the transparent multilayer film exhibits a high flexibility, its application is not restricted to a particular rear window geometry. The transparent multilayer film comprises a printed TOLED region (32) arranged in the pattern of a warning triangle. A printed circuit is provided as a control unit (33) in the rear window having the warning light function (31). The control unit (33) comprises an on/off-signal receiver and a flasher circuit. The rear window having the warning light function (31) further comprises connecting means for the connection of the control unit to the power line of a vehicle. Furthermore, an activation means (on/off-switch) (34) is provided in the vehicle interior (i.e. the cockpit), which wirelessly transmits the on/off-signal to the on/off-signal receiver in the control unit (33). In case of emergency or vehicle malfunction on the road, the configuration presented in Fig. 2 has the advantage that following road users may be warned immediately and in a visually striking manner before the driver even exits the vehicle and sets up the warning triangle. Thus, the vehicle passengers may safely evacuate the vehicle and the warning triangle may be taken out of the trunk and set up safely without the risk of being overlooked by following vehicles

The use of the kit of the present invention for providing windows with an image display is not limited to the application illustrated in Fig. 2 and may also encompass the provision of image displays (e.g. safety lights such as warning triangles, warning signs, lettering or other symbols) on public safety vehicles (e.g. police cars and ambulances), utility trucks, construction vehicles, transportation vehicles (e.g. buses and taxis) or the windows of buildings (for visual alarms, advertisements, entertainment or other information). For example, the kit according to the present invention may be used to complement acoustic alarm signals (such as e.g. burglar alarm systems in vehicles or buildings) with an optical warning sign on the windows on which the kit is applied. For this purpose, the on/off -signal receiver may be configured to be coupled with the activation means for the existing acoustic alarm system.

## Claims

1. A kit for providing windows with an image display, wherein the kit comprises a transparent multilayer film which comprises:
- a release liner;
- a pressure-sensitive, optically clear adhesive layer;
- a transparent flexible substrate;
- a transparent electrically conductive layer;
- a TOLED region electrically connected with the transparent electrically conductive layer;
- an encapsulation layer configured to encapsulate the transparent conductive oxide and the TOLED region; and
- a protective film.

2. The kit according to claim 1, wherein the transparent multilayer film is a stack of layers including at least the following layers in succession in the following order:
- a release liner;
- a pressure-sensitive, optically clear adhesive layer;
- a transparent flexible substrate;
- a transparent electrically conductive layer;
- a TOLED region electrically connected with the transparent electrically conductive layer;
- an encapsulation layer configured to encapsulate the transparent conductive oxide and the TOLED region; and
- a protective film.

3. The kit according to claims 1 or 2, wherein the multilayer film further comprises an optically transparent light guiding layer, wherein one surface of the optically transparent light guiding layer comprises a plurality of grooves having an optical path changing slope.

4. The kit according to claims 1 or 2, comprising an optically transparent light guiding film provided separately from the multilayer film, the optically transparent light guiding film comprising an optically transparent light guiding layer and an adhesive layer, wherein one surface of the optically transparent light guiding layer comprises a plurality of grooves having an optical path changing slope.

5. The kit according to claims 3 or 4, wherein said optical path changing slope is configured so that the optical path of the light emitted from the TOLED region is redirected towards the horizontal plane.

6. The kit according to any of claims 1 to 5, wherein the transparent multilayer film further comprises a control unit provided as a printed circuit.

7. The kit according to any of claims 1 to 6, wherein the transparent multilayer film further comprises a printed flasher circuit.

8. The kit according to any of claims 1 to 7, further comprising an on/off-signal receiver.

9. The kit according to any of claims 1 to 9, wherein the image display has a safety light function and/or wherein the TOLED region is provided in the pattern of a warning triangle.

10. The kit according to any of claims 1 to 9, further comprising an activating means for activating the image display.

11. A window comprising a window base material and a transparent multilayer film provided on one surface of the window base material, wherein the multilayer film comprises:
- an optically clear adhesive layer attached to one surface of the window base;
- a transparent flexible substrate layer;
- a transparent electrically conductive layer;
- a TOLED region electrically connected with the transparent electrically conductive layer;
- an encapsulation layer configured to encapsulate the electrically conductive layer and the TOLED region; and
- a protective film.

12. The window according to claim 11, further comprising an optically transparent light guiding layer.

13. The window according to claim 11, wherein the optically transparent light guiding layer is comprised in the multilayer film.

14. The window according to any of claims 11 to 13, wherein the window is a back window of a vehicle.

15. Use of a kit according to any of claims 1 to 10 in order to provide windows with an image display, the use comprising the steps of:
- removing the release liner of the transparent multilayer film, and
- adhering the transparent multilayer film to one surface of a window.
